# DEMANDE DE BREVET EUROPEEN

(11) **EP 2 369 636 A2**
(43) Date de publication de la demande: **28.09.2011**
(21) Numéro de dépôt: 11170586.9
(22) Date de dépôt: 23.01.2002
(51) Int. Cl.: H01L 31/0392, H01L 31/0336, H01L 31/0224

(54) **Substrat transparent muni d'une electrode**

(30) Priorité: 31.01.2001 FR 0101292
(62) Demande divisionnaire de: 02700381.3
(71) Demandeur: Saint-Gobain Glass France, 92400 Courbevoie (FR)
(72) Inventeur: Janke, Nikolas, 52134 HERZOGENRATH (DE); Blieske, Ulf, 68535 EDINGEN NECKARHAUSEN (DE); Fix, Renaud, 75013 PARIS (FR); Heitz, Thibaut, 600018 CHENNAI (IN); Rondeau, Véronique, 92600 ASNIERES SUR SEINE (FR); Neander, Bertrand, 52249 ESCHWEILER (DE)
(74) Mandataire: Neuviale, Bertrand

(57) **Abrégé**

L'invention a pour objet un substrat, notamment transparent, notamment en verre, qui est muni d'une électrode, notamment pour cellule solaire, comprenant une couche conductrice à base de molybdène Mo d'au plus 500 nm d'épaisseur, notamment d'au plus 400 nm ou d'au plus 300 nm ou d'au plus 200 nm.

## Description

L'invention se rapporte à un substrat, notamment transparent, notamment en verre, qui est muni d'une électrode. Ce substrat conducteur est tout particulièrement destiné à faire partie de cellules solaires.

En effet, de façon connue, les cellules solaires intègrent ce type de substrat conducteur, ensuite revêtu d'une couche d'agent absorbeur, généralement en chalcopyrite de cuivre Cu, d'indium In, et de sélénium Se et/ou de soufre S. Il peut s'agir, par exemple, d'un matériau du type CuInSe₂, Ce type de matériau est connu sous l'abréviation CIS.

Pour ce type d'application, les électrodes sont le plus souvent à base de molybdène Mo, car ce matériau présente un certain nombre d'avantages : c'est un bon conducteur électrique (résistance spécifique relativement faible de l'ordre de 5,2 mW.cm). Il peut être soumis aux traitements thermiques élevés nécessaires, car il a un point de fusion élevé (2610°C). Il résiste bien, dans une certaine mesure, au sélénium et au soufre. Le dépôt de la couche d'agent absorbeur impose le plus souvent un contact avec une atmosphère contenant du sélénium ou du soufre qui tend à détériorer la plupart des métaux. Au contraire, le molybdène réagit en surface, avec le sélénium notamment, formant du MoSe₂. Mais il garde l'essentiel de ses propriétés, notamment électriques, et conserve un contact électrique adéquat avec la couche de CIS. Enfin, c'est un matériau qui adhère bien aux couches CIS, il tend même à en favoriser leur croissance cristalline.

Cependant, il présente un inconvénient important quand on envisage une production industrielle : c'est un matériau coûteux. En effet, les couches en Mo sont habituellement déposées par pulvérisation cathodique (assistée par champ magnétique). Or les cibles de Mo sont onéreuses. Cela est d'autant moins négligeable que pour obtenir le niveau de conductivité électrique voulu (une résistance par carré inférieure à 2, et de préférence inférieure à 1 ou 0.5 ohm.carré après traitement dans une atmosphère contenant du S ou du Se), il faut une couche de Mo épaisse, généralement de l'ordre de 700 nm à 1 micromètre.

L'invention a alors pour but l'obtention d'un substrat muni d'une électrode, destinée à des cellules solaires, qui soit d'une fabrication plus simple et/ou moins onéreuse que les électrodes de Mo connues, mais dont les performances, notamment électriques, soient équivalentes ou tout au moins suffisantes pour l'application envisagée.

L'invention a tout d'abord pour objet un substrat, notamment transparent, notamment en verre, muni d'une électrode, notamment adaptée pour des cellules solaires, et qui comprend une couche conductrice à base de molybdène Mo d'au plus 500 nm, notamment d'au plus 400 ou d'au plus 300 ou d'au plus 200 nm. Elle a une épaisseur qui, de préférence, est d'au moins 20 nm, ou d'au moins 50 ou 80 ou 100 nm.

Au sens de l'invention, on entend par couche soit une couche continue, soit une couche discontinue, présentant notamment des motifs (soit par gravure d'une couche continue, soit par dépôt directement de la couche discontinue au motif voulu, par un système de masque par exemple). Cela s'applique à toutes les couches dont il est question dans la présente demande.

La démarche de l'invention n'a pas consisté à supprimer complètement le molybdène au profit d'un autre métal, car aucun n'a été jugé susceptible de résister suffisamment, notamment au contact avec le sélénium ou le soufre et aux traitements thermiques évoqué plus haut, sans dégradation importante (le problème de la dégradation possible du Mo touche de la même façon la couche d'agent absorbeur qui le recouvre). Par contre, la démarche a été de diminuer significativement l'épaisseur de molybdène : il s'est avéré, contre toutes attentes, que des épaisseurs bien inférieures à celles utilisées habituellement, bien inférieures à 1 micromètre, suffisaient tout-à-fait pour obtenir les performances électriques voulues, avec en conséquence un gain appréciable en termes de coût de matières premières. Diminuer l'épaisseur de la couche de molybdène présente un autre avantage: il s'est avéré que l'on pouvait se permettre de déposer ces couches relativement fines par pulvérisation cathodique avec des paramètres de dépôt conduisant à des couches fortement contraintes, sans les problèmes de délamination que l'on peut rencontrer dans ce cas-là avec des couches épaisses. Des couches plus minces tendent en outre à présenter moins de défauts connus sous le terme de "pinholes" (trous d'épingles).

Pour garantir que des couches de molybdène plus minces gardent toute leur efficacité, l'invention a recours, de préférence, de façon alternative ou cumulative, à plusieurs variantes (qui restent cependant optionnelles).

Selon une première variante, on insère avantageusement entre le substrat et l'électrode une couche dite couche-barrière. Sa fonction principale est de faire barrage à la migration d'espèces diffusantes hors du substrat vers l'électrode et jusqu'à la couche d'agent absorbeur (et éventuellement, réciproquement, des espèces diffusantes de l'électrode vers le substrat). Quand le substrat est en verre, les espèces susceptibles de diffuser hors du verre et de dégrader l'électrode et la couche d'agent absorbeur sont notamment les alcalins. Prévoir une telle couche-barrière permet d'utiliser comme substrat du verre standard silico-sodo-calcique obtenu par flottage, sans risquer de détériorer l'électrode, ni la couche d'agent absorbeur en chalcopyrite. Ceci est, dans le cadre de l'invention, d'autant plus important que la couche de molybdène est mince, et qu'une dégradation même sur une faible épaisseur aurait un impact plus important que sur une couche beaucoup plus épaisse.

Cette couche-barrière, avantageusement, est à base de matériau diélectrique choisi parmi au moins l'un des composés suivantes : nitrure ou oxynitrure de silicium, nitrure ou oxynitrure d'aluminium, oxyde ou oxynitrure de silicium. Le nitrure de silicium (contenant éventuellement un métal minoritaire du type Al ou du bore) s'est avéré particulièrement efficace. C'est un matériau très inerte, peu sensible aux traitements thermiques et bloquant de manière satisfaisante la diffusion des alcalins.

De préférence, la couche-barrière a une épaisseur d'au moins 20 nm, notamment d'au moins 100 nm ou 120 ou 150 nm, et une épaisseur d'au plus 300 nm, notamment d'au plus 250 ou 200 nm.

Selon une seconde variante, on peut vouloir « compenser » la diminution d'épaisseur de la couche en Mo, pour obtenir une électrode qui, globalement, est aussi conductrice voire plus conductrice qu'une couche de Mo épaisse. La solution selon l'invention consiste à ajouter, dans l'électrode, à la couche à base de Mo, au moins une autre couche conductrice de nature différente. On choisit avantageusement cette ou ces couches conductrices « complémentaires » en des matériaux moins coûteux à déposer en couche mince que le molybdène (par pulvérisation cathodique).

La couche conductrice complémentaire, ou l'ensemble des couches conductrices complémentaires s'il y en a plusieurs, a de préférence une épaisseur d'au moins 10 nm, notamment d'au moins 40 nm. De préférence, elle a une épaisseur d'au plus 300 nm, et on la choisit avantageusement dans une gamme allant de 50 à 200 ou 300 nm.

Selon un premier mode de réalisation de cette seconde variante, l'électrode comprend au moins une couche conductrice complémentaire dite M à base de métal ou d'un alliage d'au moins deux métaux. Il peut s'agir, notamment des métaux ou alliages suivants : Cu, Ag, Al, Ta, Ni, Cr, NiCr, acier. On a avantage à disposer cette ou ces couches métalliques complémentaires en dessous de la couche à base de molybdène : dans cette configuration, la couche de molybdène isole ces couches métalliques du contact avec le sélénium ou le soufre, qui sont particulièrement corrosifs et auxquels le molybdène résiste de façon correcte.

Selon un second mode de réalisation de la seconde variante, alternatif ou cumulatif avec le premier mode, l'électrode comprend au moins une couche conductrice complémentaire dite M'N à base d'un nitrure métallique ; il s'agit notamment d'un nitrure d'au moins un des métaux suivants : Ta, Zr, Nb, Ti, Mo, Hf. Cette couche peut être située en dessous ou au-dessus de la couche à base de molybdène (voire être au nombre de deux, l'une en dessous et l'autre au-dessus de ladite couche). Le nitrure peut être stoechiométrique, sous-stoechiométrique ou sur-stoechiométrique en azote. On peut ajuster la stoechiométrie, notamment en faisant varier le pourcentage d'azote dans la chambre de pulvérisation quand on dépose la couche par pulvérisation cathodique réactive à partir d'une cible métallique.

Un mode de réalisation particulièrement avantageux consiste à cumuler les deux précédents, en prévoyant une couche M'N entre une couche M et la couche à base de Mo. Dans cette configuration, en effet, la couche de nitrure M'N joue non seulement le rôle de couche conductrice, mais également celui d'une couche venant empêcher (ou tout au moins diminuer significativement) toute interdiffusion d'espèces entre les deux couches métalliques (M et Mo). Ainsi, il s'est avéré que des couches de TiN, TaN, ZrN, NbN et MoN étaient efficaces pour empêcher la diffusion du cuivre vers la couche de molybdène. Il a été aussi montré que les couches de HfN étaient particulièrement efficaces pour empêcher la diffusion d'aluminium vers la couche de molybdène (ce type de formule HfN, etc... ne préjuge pas de la stoechiométrie du nitrure, il peut s'agir aussi d'un nitrure sous- ou sur-stoechiométrique, comme pour toutes les autres formules de nitrure mentionnées dans le présent texte).

On peut avoir, par exemple, des configurations d'électrodes selon l'invention qui comprennent les séquences de couches suivantes :
M/Mo/M'N
M/M'N/Mo
M/Mo
M'N/Mo
Mo/M'N

Dans le cas où la couche de métal M est à base d'argent, il est préférable d'assurer sa bonne adhérence à la couche sous jacente (par exemple la couche-barrière du type Si₃N₄ dans une configuration :
couche-barrière/couche M/couche M'N/couche Mo.
en insérant entre ladite couche-barrière et ladite couche à base d'argent une couche de nucléation à base d'oxyde de zinc. Il peut aussi être intéressant, toujours pour assurer une meilleure cohésion à l'empilement, de prévoir une seconde couche à base d'oxyde de zinc au-dessus de la couche d'argent. La ou les couches à base de ZnO éventuellement dopé (Al, B ...) sont par exemple choisies d'une épaisseur d'au moins 5 nm, par exemple entre 7 et 20 nm.

De préférence, la somme des épaisseurs des couches conductrices de l'électrode est inférieure ou égale à 600 nm, notamment inférieure ou égale à 500 ou 400 nm.

L'électrode a avantageusement une résistance par carré inférieure ou égale à 2Ω/□, notamment inférieure ou égale à 1Ω/□, de préférence inférieure ou égale à 0,50 ou 0,45Ω/□: ces valeurs sont appropriées pour des électrodes de cellule solaire.

Selon une variante préférée, l'invention a cherché à améliorer l'aspect de la cellule solaire. En effet, quand la cellule solaire équipe des façades ou des toitures de bâtiment, son aspect « côté intérieur » du bâtiment (du côté extérieur, l'électrode fait un miroir) n'est pas toujours très esthétique. La colorimétrie en réflexion est susceptible d'amélioration.

Une première solution à ce problème subsidiaire selon l'invention a consisté à inclure la couche-barrière précédemment évoquée dans un revêtement multicouches à but optique « sous » l'électrode à proprement dit. Le revêtement optique est constitué d'au moins deux couches de matériaux diélectriques d'indices de réfraction différents. En jouant sur les épaisseurs et les différences d'indices entre les couches, on peut ainsi régler assez finement la colorimétrie du substrat à couches en réflexion, par interférence.

Ce revêtement, de préférence, comprend une alternance de couches à haut indice (1,9 à 2,3 par exemple) et des couches à bas indice (1,4 à 1,7 par exemple). Des modes de réalisation de ce revêtement sont, par exemple : Si₃N₄/SiO₂ ou Si₃N₄/SiO₂/Si₃N₄.

Une seconde solution, alternative ou cumulative avec la première, consiste à utiliser des électrodes contenant au moins une couche à base de nitrure M'N et à modifier (légèrement) la stoechiométrie de l'azote. Il s'est en effet avéré que des nitrures légèrement sous-ou sur-stoechiométriques gardaient les mêmes propriétés électriques, mais permettaient de faire varier dans une certaine mesure la colorimétrie du substrat. En combinant les deux solutions, on augmente les possibilités d'ajustement de la colorimétrie.

Une troisième solution, alternative ou cumulative avec l'une au moins des deux premières solutions, consiste à disposer sous l'électrode, notamment à interposer entre la couche-barrière et l'électrode, une fine couche absorbante dans le visible. Il peut par exemple s'agir de couches en nitrure de métal, du type TiN, et elles ont de préférence une épaisseur cantonnée à une gamme allant de 2 à 15 nm. On peut avoir ainsi une séquence de couches du type verre/ couche-barrière comme Si₃N₄/fine couche absorbante comme TiN/SiO₂/Mo :dans ce cas, la couche absorbante se trouve "au milieu" du revêtement optique Si₃N₄/SiO₂.

On peut ainsi obtenir un substrat muni de ce revêtement et de l'électrode qui, en réflexion, a des valeurs de a* et b* négatives dans les systèmes de colorimétrie (L, a*, b*), ce qui correspond à des couleurs dans les bleus-verts, ou une valeur de a* légèrement positive et une valeur de b* négative, ce qui correspond à une couleur dans les rosés.

L'invention a aussi pour objet le substrat précédemment défini et recouvert, au-dessus de l'électrode, par une couche d'agent absorbeur de chalcopyrite.

Elle a aussi pour objet ledit substrat pour faire des cellules solaires.

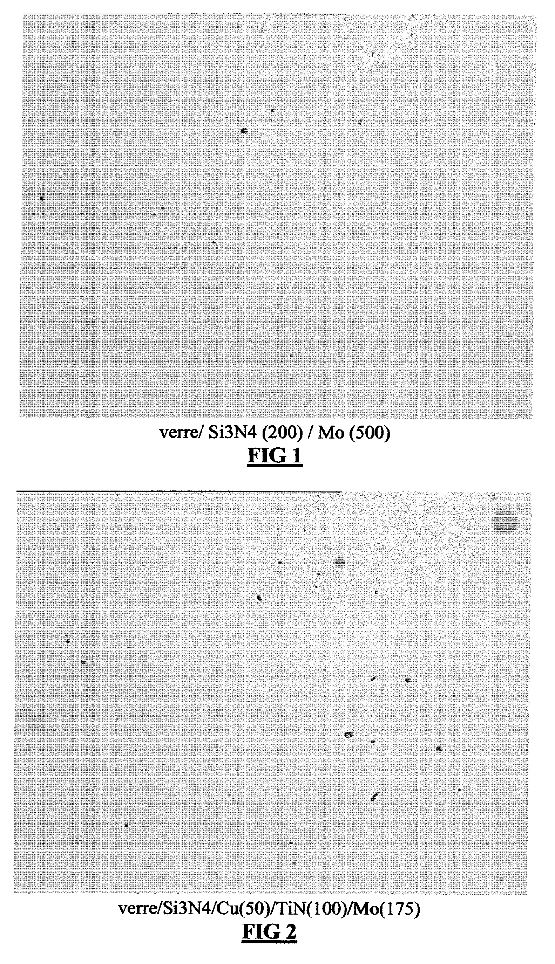

L'invention sera maintenant détaillée à l'aide d'exemples de réalisation, non limitatifs, d'électrodes pour cellules solaires illustrés aux figures 1 et 2 par des photos d'agrandissement des verres à couches.

Chaque exemple utilise un substrat de verre silico-sodo-calcique clair de 2 mm d'épaisseur. (les verres ont généralement une épaisseur entre 1 et 4 ou entre 1 et 3 mm.)

L'ensemble des couches est déposé sur les verres par pulvérisation cathodique assistée par champ magnétique :
™ les couches de métal à partir de la cible de métal correspondante, en atmosphère inerte,
™ les couches de nitrure de métal à partir de la cible de métal correspondante, en atmosphère réactive contenant un mélange de gaz inerte et d'azote,
™ les couches de nitrure de silicium à partir d'une cible de Si dopé (Al), en atmosphère réactive contenant un mélange de gaz inerte et d'azote,
™ les couches d'oxyde de silicium à partir d'une cible de Si (dopé Al) et d'une atmosphère réactive comprenant un mélange de gaz inerte et d'oxygène.

Les couches sont testées de la façon suivante :
← - mesure de la résistance par carré R□ (1) par la méthode des quatre points après dépôt de toutes les couches,
↑ - test appelé « bronze test » : ce test consiste à chauffer le verre muni de toutes les couches à 350°C pendant 10 minutes à l'air. Il est destiné à vérifier s'il y a eu ou non diffusion du sodium du verre vers l'électrode. A la fin du test, on mesure la résistance par carré, R□ (2), toujours par la méthode des quatre points. On vérifie aussi au microscope (à des agrandissements x100 et x1000) si le traitement thermique a provoqué ou non des défauts (piqûres), ...
→ - test dit « test de sélénisation » : ce test consiste à chauffer à nouveau les verres munis de toutes les couches sous une atmosphère de sélénium pendant 10 minutes. La température du sélénium est entre 200 et 240°C, la température du verre est entre 325 et 365°C. A la fin du test, on mesure à nouveau la résistance par carré R□ (3) et on en déduit la différence de résistivité avant/après sélénisation Δ R□ (3).

Il est à noter que ce test de sélénisation est en fait beaucoup plus "dur" qu'il ne l'est dans la réalité. En effet, l'invention est ici intéressée à ne fabriquer dans un premier temps que les électrodes. Cependant, quand on fabrique la cellule solaire dans son ensemble, cette étape de sélénisation se fait une fois la couche en CIS déposée : dans le cycle de fabrication normal d'une cellule solaire, l'électrode est « protégée » du contact direct avec le sélénium par la couche de chalcopyrite.

Pour que les électrodes soient considérées comme satisfaisantes, il est jugé avantageux :
™ que le sodium du verre soit empêché de diffuser vers l'électrode,
™ que l'électrode ait une certaine résistance au « bronze test » et au « test de sélénisation » : peu de défauts, résistance par carré suffisante.
™ que l'électrode adhère bien aux couches du type CIS,
™ que l'électrode soit aisément gravable, notamment par laser.

### EXEMPLES 1 à 7

### Exemple 1

Cet exemple utilise une couche-barrière et une électrode mono-couche en molybdène, selon la séquence :
Verre/Si₃N₄ (200 nm)/Mo (500 nm)

La figure 1 est un agrandissement à mille fois sous microscope du verre, après l'étape de sélénisation : la photo montre peu de défauts, de petite taille de surcroît. On considère que la qualité de l'électrode est bonne.

### Exemple 1 bis

Cet exemple utilise le même empilement de couches qu'à l'exemple 1, mais avec une couche en Mo nettement plus mince, selon la séquence :
Verre/Si₃N₄ (200nm)/Mo (200 nm)

### Exemple 2

Cet exemple utilise une couche-barrière, et une électrode bi-couche, couche de métal M puis couche Mo, selon la séquence suivante :
Verre/Si₃N₄ (200 nm)/Ag (50 nm)/Mo (175 nm)

### Exemple 3

Cet exemple utilise la même configuration que l'exemple 2 , mais avec un autre type de couche métal M :
Verre/Si₃N₄ (200 nm)/Al (100 nm)/Mo (175 nm)

### Exemple 4

Cet exemple utilise une couche-barrière et une électrode tri-couche métal/nitrure métallique/Mo selon la séquence :
Verre/Si₃N₄ (200 nm)/Cu (100 nm)/TiN (100 nm)/Mo (175 nm)

### Exemple 5

C'est la même configuration que l'exemple 4, avec une épaisseur différente pour la couche de cuivre :
Verre/Si₃N₄ (200 nm)/Cu (50 nm)/TiN (100 nm)/Mo (175 nm)

La figure 2 correspond à une photo d'un agrandissement 1000 fois à l'aide d'un microscope de cet exemple 5, d'une portion du verre à couches après le test de sélénisation : on voit peu de défauts, de taille très petite. C'est un cliché tout-à-fait comparable à la photo selon la figure 1.

### Exemple 6

Cet exemple utilise une couche-barière et une électrode tri-couche, selon la séquence suivante :
Verre/Si₃N₄ (200 nm)/Ag (50 nm)/TiN (100 nm)/Mo (175 nm)

Il correspond à l'exemple 2, avec en plus une couche de TiN.

### Exemple 7

Cet exemple utilise toujours une couche-barrière et une électrode tri-couche, selon la séquence suivante :
Verre/Si₃N₄ (200 nm)/Al (100 nm)/TiN (100 nm)/Mo (175 nm)

Il correspond à l'exemple 3, avec une couche de TiN en plus.

La tableau 1 ci-dessous regroupe, pour chacun des exemples 1 à 7, les valeurs de R□(1), R□(2), l'évaluation des défauts après le bronze test (" défauts ", et ΔR□ (3), ces termes ayant été explicités plus haut.

**TABLEAU 1**

| **EXEMPLES** | **R□(1)** | **R□(2)** | **DEFAUTS** | **ΔR□(3),** |
|---|---|---|---|---|
| **Ex. 1** | 0.37 | 0.37 | Aucun | 0 à-5% |
| Si₃N₄/Mo | | | | |
| **Ex. 1 bis** | 0.98 | 0.96 | Aucun | 0 à-3% |
| Si₃N₄/Mo | | | | |
| **Ex. 2** | 0.42 | 0.42 | Aucun | -17% |
| Si₃N₄/Ag/Mo | | | | |
| **Ex. 3** | 0.36 | 0.34 | Aucun | - |
| Si₃N₄/Al/Mo | | | | |
| **Ex. 4** | 0.45 | 0.45 | Aucun | -9% |
| Si₃N₄/Cu/TiN/Mo | | | | |
| **Ex. 5** | 0.44 | 0.44 | Aucun | -10% |
| Si₃N₄/Cu/TiN/Mo | | | | |
| **Ex. 6** | 0.44 | 0.44 | Aucun | - 12 % |
| Si₃N₄/Ag/TiN/Mo | | | | |
| **Ex. 7** | 0.38 | 0.36 | Aucun | - |
| Si₃N₄/Al/TiN/Mo | | | | |

De ces données peuvent être tirées les conclusions suivantes :

On peut obtenir une valeur de R□ nettement inférieure à 1 ohm/carré avec moins de 200 nm de molybdène, que l'on associe avec une couche de nitrure métallique et/ou de métal d'épaisseurs raisonnables (en tout, les électrodes bi ou tri-couches restent d'une épaisseur globale inférieure à 400 ou 500 nm).

Les couches-barrières en Si₃N₄ sont efficaces, et empêchent la détérioration de l'électrode par diffusion du sodium, puisque dans tous les exemples, les valeurs de R□ (1) et R□(2) sont les mêmes ou quasiment les mêmes. Elles empêchent donc également la détérioration de la couche d'agent absorbeur type CIS.

On peut choisir aussi d'avoir une électrode mono-couche en Mo (exemple 1, avec 500 nm et associée à une couche-barrière. Elle donne de bons résultats: On peut encore avoir une résistance par carré inférieure à 1 ohm.carré avec une électrode composée seulement de 200 nm de Mo. Cela prouve qu'il est inutile d'avoir recours à une couche de Mo bien plus épaisse comme cela a pu se faire jusqu'ici.

### EXEMPLES 8 à 11 TER

Ces exemples ont pour but d'ajuster la colorimétrie de l'électrode en réflexion.

La couche de molybdène est dans tous ces exemples d'une épaisseur de 400 nm ou 500 nm. Sur le plan de la colorimétrie côté verre, elle n'a pas d'influence à partir du moment où elle est épaisse d'au moins 50 à 100 nm, puisqu'elle est alors une couche-miroir parfaitement opaque : les résultats seraient donc les mêmes avec une couche de Mo de 175 ou 200 nm.

### Exemple 8

Cet exemple utilise l'empilement suivant :
Verre/Si₃N₄ (200 nm)/TiN (100 nm)/Mo (400 nm)

La couche de TiN étant déposée par pulvérisation réactive dans une atmosphère réactive contenant 20 % en volume d'azote.

### Exemple 8bis

Il s'agit de la même configuration qu'à l'exemple 8, mais ici la couche de TiN a été déposée dans une atmosphère contenant 40 % d'azote.

### Exemple 8 ter

Il s'agit de la même configuration qu'à l'exemple 8, mais ici la couche de TiN a été déposée dans une atmosphère contenant 70 % d'azote.

Le tableau ci-dessous regroupe pour ces trois exemples des valeurs de a* et b*, selon le système de colorimétrie (L, a*, b*) mesurées côté verre, ainsi que les valeurs de R□ (mesures faites avant le « bronze » test)

| **EXEMPLES** | **a*** | **b*** | **R□ (ohm.carré)** |
|---|---|---|---|
| Ex. 8 | - 8,6 | 19,4 | 0,44 |
| Ex. 8bis | -9,2 | 1,5 | 0,38 |
| Ex. 8ter | -11,6 | -3,6 | 0,35 |

On constate que la variation dans la stoechiométrie au TiN (en fonction du taux de N₂ lors du dépôt) ne modifie pas significativement les propriétés électriques de l'électrode. Par contre, elle permet de modifier beaucoup les valeurs de a*, et, plus encore, de b* : l'exemple 8 est ainsi coloré dans les rouges, avec un b* très positif, alors que l'exemple 8ter est dans les bleus-verts, avec un b* légèrement négatif.

L'exemple 8 a une couche de TiN légèrement sous-stoechiométrique, l'exemple 8bis a une couche de TiN approximativement stoechiométrique, tandis que l'exemple 8ter a tendance à être sur-stoechiométrique en azote.

### Exemple 9

Dans cet exemple, la couche-barrière en Si₃N₄ (indice de réfraction d'environ 2) est associée à une couche supplémentaire à base de SiO₂ (indice de réfraction d'environ 1,45) pour faire un revêtement optique haut indice/bas indice.

La configuration est la suivante :
Verre/Si₃N₄ (200 nm)/SiO₂ (20 nm)/TiN (100 nm)/Mo (400 nm)

La couche de TiN est déposée dans une atmosphère ayant 20 % en volume d'azote.

### Exemple 9bis

On réplique l'exemple 9, avec cette fois 40 % d'azote dans l'atmosphère de dépôt du TiN.

### Exemple 9ter

On réplique l'exemple 9, avec cette fois 70 % d'azote dans l'atmosphère de dépôt du TiN.

Le tableau ci-dessous regroupe pour ces 3 exemples, les valeurs de a*, b* et Rcarré explicitées plus haut.

| **EXEMPLES** | **a*** | **b*** | **R□ (ohm.carré)** |
|---|---|---|---|
| Ex. 9 | - 8,1 | 22,5 | 0,34 |
| Ex. 9bis | -10,6 | -8,3 | 0,38 |
| Ex. 9ter | -14,0 | 5,5 | 0,35 |

### Exemple 10

Cette fois, la couche de nitrure utilisée est en NbN, selon la configuration suivante :
Verre/Si₃N₄ (200 nm)/SiO₂ (30 nm/NbN (100 nm)/Mo (500 nm)

La couche de NbN a été déposée dans une atmosphère contenant 20 % d'azote.

### Exemple 10bis

On réplique l'exemple 10, mais ici la couche de NbN a été déposée dans une atmosphère contenant 40 % d'azote.

### Exemple 10ter

On réplique l'exemple 10, mais ici la couche de NbN a été déposée dans une atmosphère contenant 70 % d'azote.

Le tableau ci-dessous regroupe pour ces trois exemples les valeurs de a*, b* et Rcarré déjà explicitées :

| **EXEMPLES** | **a*** | **b*** | **R□ (ohm/carré)** |
|---|---|---|---|
| Ex. 10 | -14 | -0,5 | 0,29 |
| Ex. 10bis | -10,6 | -9,2 | 0,37 |
| Ex. 10ter | -17,6 | -0,9 | 0,42 |

Ici, que le NbN soit plutôt sous ou sur-stoechiométrique, les valeurs de a* et b* sont négatives, ce qui correspond à une couleur bleu-verte esthétique, dont l'intensité varie.

### Exemple 11

Cet exemple reprend la séquence de couches des exemples 10, 10bis, 10ter, mais avec des épaisseurs de Si₃N₄ et de SiO₂ différentes.

La configuration est la suivante :
Verre/Si₃N₄ (150 nm)/SiO₂ (90 nm)/NbN (100 nm)/Mo (500 nm)

### Exemple 11 bis

Cet exemple réplique l'exemple 11, mais ici la couche de NbN a été déposée dans une atmosphère contenant 40 % d'azote.

### Exemple 11 ter

Cet exemple réplique l'exemple 11, mais ici la couche de NbN a été déposée dans une atmosphère contenant 70 % d'azote.

Le tableau ci-dessous regroupe pour ces trois exemples les valeurs de a*, b* et Rcarré déjà explicitées :

| **EXEMPLES** | **a*** | **b*** | **R□ (ohm/carré)** |
|---|---|---|---|
| Ex. 11 | 0,3 | -7,6 | 0,34 |
| Ex. 11bis | 2,8 | -10,3 | 0,33 |
| Ex. 11ter | 8,8 | -14,2 | 0,28 |

Ces exemples sont donc dans les rosés, couleur également jugée esthétique.

### Exemple 12

Cet exemple présente la séquence de couches suivante :
Verre/ Si₃N₄ (150 nm)/SiO₂ (65 nm)/Si₃N₄ (15 nm)/Mo (500nm)

Il intègre donc la couche-barrière dans un revêtement optique à trois couches haut indice/bas indice/haut indice de réfraction.

Le tableau ci-dessous reprend les mêmes données pour cet exemple que dans les exemples précédents.

| **EXEMPLE** | **a*** | **b*** | **R□ (ohm/carré)** |
|---|---|---|---|
| Ex. 12 | - 4.1 | -6.3 | 0,28 |

Cet exemple a donc une couleur dans les bleus-verts, de surcroit peu intense.

En conclusion, on peut donc ajuster finement la couleur des électrodes selon l'invention en jouant sur la stoechiométrie de la couche de nitrure et/ou en ajoutant un filtre à au moins deux couches incluant avantageusement la couche-barrière. On a par ailleurs vérifié que les valeurs de a* et b* de cette seconde série d'exemples variaient peu (moins de ± 2) une fois passé le « bronze » test.

## Revendications

1. Substrat, notamment transparent, notamment en verre, muni d'une électrode, notamment pour cellule solaire, **caractérisé en ce que** l'électrode comprend une couche conductrice à base de molybdène Mo d'au plus 500 nm d'épaisseur, notamment d'au plus 400 nm ou d'au plus 300 nm ou d'au plus 200 nm.

2. Substrat selon la revendication 1, **caractérisé en ce qu'**il est muni d'au moins une couche-barrière, notamment vis-à-vis des alcalins, insérée entre ledit substrat et ladite électrode.

3. Substrat selon l'une des revendications précédentes, **caractérisé en ce que** l'électrode comprend au moins une couche conductrice complémentaire, différente de la couche à base de molybdène.

4. Substrat selon la revendication 3, **caractérisé en ce que** la couche conductrice complémentaire, ou au moins l'une d'entre elles s'il y en a au moins deux, a une épaisseur d'au moins 10 nm, notamment d'au moins 40 nm, et de préférence d'au plus 300 nm, avec de préférence une épaisseur comprise entre 50 et 200 nm.

5. Substrat selon la revendication 3 ou la revendication 4, **caractérisé en ce que** l'électrode comprend au moins une couche conductrice complémentaire M à base de métal ou d'alliage métallique, notamment choisi parmi l'un des métaux ou alliages suivants : Cu, Ag, Al, Ta, Ni, Cr, NiCr, acier.

6. Substrat selon l'une des revendications 3 à 5, **caractérisé en ce que** l'électrode comprend au moins une couche conductrice complémentaire M à base de métal ou d'alliage métallique en-dessous de la couche conductrice à base de molybdène Mo.

7. Substrat selon l'une des revendications 3 à 6, **caractérisé en ce que** l'électrode comprend au moins une couche conductrice complémentaire M'N à base d'un nitrure sous-stoechiométrique, stoechiométrique ou sur-stoechiométrique, en azote, d'au moins un des métaux suivants : Ta, Zr, Nb, Ti, Mo, Hf.

8. Substrat selon la revendication 7, **caractérisé en ce que** la couche M'N est en-dessous et/ou au-dessus de la couche à base de molybdène Mo.

9. Substrat selon la revendication 5 et la revendication 7, **caractérisé en ce que** la couche M'N est disposée entre la couche M et la couche à base de Mo.

10. Substrat selon la revendication 5 et/ou la revendication 7, **caractérisé en ce que** l'électrode comporte l'une des séquences de couches suivantes : M/Mo/M'N ; M/M'N/Mo ; M/Mo ; M'N/Mo ; Mo/M'N.

11. Substrat selon l'une des revendications précédentes, **caractérisé en ce que** la somme des épaisseurs des couches conductrices de l'électrode est inférieure ou égale à 600 nm, notamment inférieure ou égale à 500 nm.

12. Substrat selon l'une des revendications précédentes, **caractérisé en ce que** l'électrode a une résistance par carré R□ inférieure ou égale à 2Ω/□, notamment inférieure ou égale à 1Ω/□, de préférence inférieure ou égale à 0,50 ou 0,45Ω/□.

13. Substrat selon la revendication 2, **caractérisé en ce que** la couche-barrière fait partie d'un revêtement multicouches à but optique, constitué d'au moins deux couches de matériaux diélectriques d'indices de réfraction différents.

14. Substrat selon l'une des revendications précédentes, **caractérisé en ce qu'**il comprend au-dessus de l'électrode une couche d'agent absorbeur de chalcopyrite.

15. Cellule solaire, **caractérisée en ce qu'**elle comprend le substrat selon la revendication 14.
